# EUROPEAN PATENT SPECIFICATION

(11) **EP 3 531 557 B1**
(45) Date of publication and mention of the grant of the patent: **08.05.2024**
(21) Application number: 18205573.1
(22) Date of filing: 12.11.2018
(51) Int. Cl.: H03K 17/95

(54) **PROXIMITY SENSOR**
NÄHERUNGSSENSOR
DÉTECTEUR DE PROXIMITÉ

(30) Priority: 21.02.2018 JP 2018028652
(43) Date of publication of application: 28.08.2019
(73) Proprietor: Omron Corporation, Kyoto-shi, Kyoto 600-8530 (JP)
(72) Inventor: Okamoto, Takuya, Kyoto, 600-8530 (JP); Nakayama, Yusuke, Kyoto, 600-8530 (JP); Tsuchida, Hiroyuki, Kyoto 600-8530 (JP)
(74) Representative: Ter Meer Steinmeister & Partner

(56) References cited:
- WO-A2-2008/013515
- DE-A1-102012 010 228
- GB-A- 2 040 054
- JP-A- 2009 059 528
- US-A1- 2006 221 061

## Description

### BACKGROUND

### Technical Field

The disclosure relates to a proximity sensor.

### Description of Related Art

Patent Document 1 (Japanese Laid-open No. 2009-059528) discloses a proximity sensor including a detection coil for generating a magnetic field, an excitation circuit for periodically supplying a pulsed excitation current to the detection coil, a detection circuit for detecting presence or absence of a metal object based on a voltage generated across both ends of the detection coil after the supply of the excitation current is cut off, and a control circuit. The control circuit controls the excitation circuit so that a supply period of the excitation current is equal to or longer than a supply cutoff period of the excitation current. Accordingly, variation in a detection distance due to thickness of a detection object may be suppressed.

However, when the excitation current is periodically supplied to the detection coil as in the proximity sensor described in Patent Document 1, for example if a periodic pulse generation source, such as an inverter, etc., is in the proximity, when the period of the pulse matches the period of the excitation current, the proximity sensor may be affected by noise due to the pulse. JP 2009 059528 A discloses a proximity sensor which includes a detecting coil for generating a magnetic field, an exiting circuit for supplying an exiting current of a pulse type to the detecting coil periodically, a detecting circuit which detects an existence of metal and its position based on a voltage generated on both ends of the detecting coil after the supply of the exiting current to the detecting coil is shutdown, and a controlling circuit. The controlling circuit controls the exiting circuit so that a supply period of the exiting current can be longer than a supply-shutdown period of the exiting current.

### SUMMARY

The objects of the present invention are solved by the features of the independent claim. Preferred embodiments are given in the dependent claims. This disclosure provides a proximity sensor which may reduce the influence of periodic noise.

A proximity sensor according to an embodiment of the disclosure is defined in independent claim 1.

According to the embodiment, since the timing of cutting off the supply of the excitation current to the detection coil is aperiodic, a start timepoint of a period for detecting the voltage of the detection coil is also aperiodic. Therefore, even if noise from outside is periodic, the probability of the noise appearing in each detection period of the voltage becomes small. Therefore, the influence of periodic noise on the proximity sensor is reduced.

In the proximity sensor according to the above embodiment, the control circuit may control the excitation circuit by varying at least one of a supply period during which the excitation circuit supplies the excitation current to the detection coil and a cutoff period during which the excitation circuit does not supply the excitation current to the detection coil so that the timing of cutting off the supply of the excitation current to the detection coil becomes aperiodic. According to the embodiment, the influence of periodic noise on the proximity sensor can be reduced using a simple method.

The proximity sensor according to the above embodiment further includes a randomizer for generating a random number. The control circuit may control the excitation circuit based on the random number generated by the randomizer so that the timing of cutting off the supply of the excitation current to the detection coil becomes aperiodic. According to the embodiment, the influence of periodic noise on the proximity sensor can be easily reduced.

According to the disclosure, a proximity sensor which may reduce the influence of periodic noise can be provided.

### BRIEF DESCRIPTION OF THE DRAWINGS

FIG. 1 is a circuit block diagram of a proximity sensor according to an embodiment.
FIG. 2 is a circuit block diagram showing a schematic configuration of basic parts of a proximity sensor according to an embodiment.
FIG. 3 is a schematic waveform diagram for explaining an excitation current and a coil voltage generated in a detection coil according to an embodiment.
FIG. 4 is a diagram showing an example of an operation waveform diagram of a conventional proximity sensor.
FIG. 5 is a diagram showing an example of an operation waveform diagram of a proximity sensor according to an embodiment.

### DESCRIPTION OF THE EMBODIMENTS

Below, an embodiment (also referred to as "the present embodiment" hereinafter) according to an aspect of the disclosure will be described with reference to the drawings. In each of the drawings, the same reference numerals are given to the same or similar configurations.

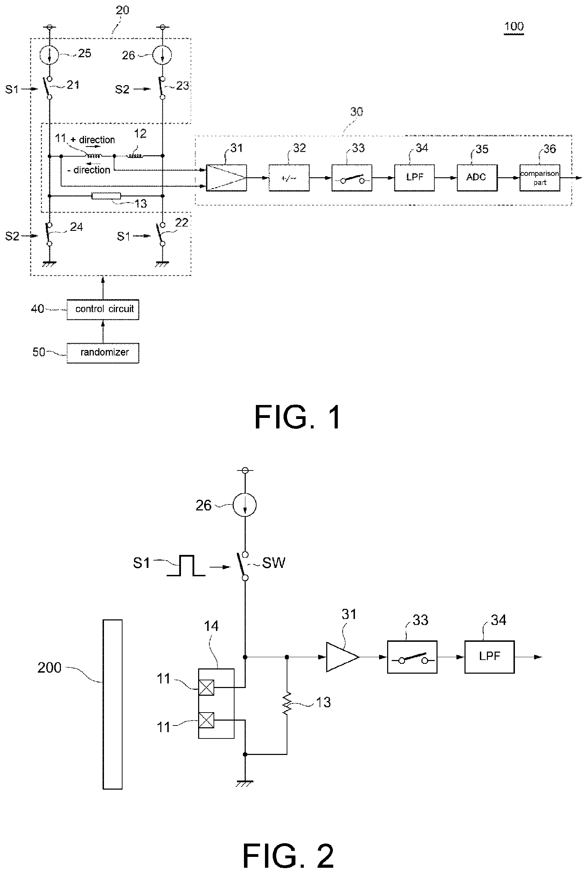

FIG. 1 exemplifies a circuit block diagram of a proximity sensor according to the present embodiment. A proximity sensor 100 is a proximity sensor for detecting a detection object using a magnetic field, including, for example, a detection coil 11, an auxiliary coil 12, a discharge resistor 13, an excitation circuit 20, a detection circuit 30, a control circuit 40, and a randomizer 50.

The detection coil 11 is, for example, a coil having two ends. The detection coil 11 is supplied with an excitation current from the excitation circuit 20 to be described later. The detection coil 11 generates a magnetic field based on the excitation current supplied to the detection coil 11. Also, a side surface of the detection coil 11 may be covered with a metal housing.

For example, in order to prevent a magnetic flux from the detection coil 11 from interlinking with a metal case body (not shown) of the proximity sensor 100 and a surrounding metal (not shown) to which the proximity sensor 100 is attached, the auxiliary coil 12 generates a magnetic field in a direction canceling the magnetic flux. Hence, as shown in FIG. 1, the auxiliary coil 12, for example, is connected in series with the detection coil 11 and a winding direction of the auxiliary coil 12 is opposite a winding direction of the detection coil 11. The auxiliary coil 12 is disposed outside the detection coil 11.

The discharge resistor 13 is, for example, a resistor for promptly converging an electrical discharge of the detection coil 11. When a resistance value of the discharge resistor 13 is R and an inductance of the detection coil 11 is L, a time constant at the time of electrical discharge of the detection coil 11 is proportional to (L/R).

The excitation circuit 20 is a circuit for repeatedly supplying a pulsed excitation current to the detection coil 11, and the excitation circuit 20 includes, for example, switches 21 to 24 and constant current circuits 25 and 26. The switches 21 and 22 may perform the same operation according to a signal S 1 from the control circuit 40, and, for example, may be turned on and off at the same time. Also, the switches 23 and 24 may perform the same operation according to a signal S2 from the control circuit 40, and, for example, may be turned on and off at the same time.

The constant current circuits 25 and 26 are, for example, circuits for supplying the excitation current to the detection coil 11. When the switches 21 and 22 are turned on, the excitation current supplied from the constant current circuit 25 flows in a + direction of the detection coil 11 as shown in FIG. 1. Also, when the switches 23 and 24 are turned on, the excitation current supplied from the constant current circuit 26 flows in a - direction of the detection coil 11 as shown in FIG. 1.

The detection circuit 30 is a circuit for detecting a detection object 200 based on a voltage generated across both ends of the detection coil 11. The detection circuit 30 includes, for example, an amplifier circuit 31, a synchronous detection circuit 32, a switching circuit 33, a low-pass filter (indicated as LPF in the drawing) 34, an A/D (Analog/Digital) converter (indicated as ADC in the drawing) 35, and a comparison part 36.

The amplifier circuit 31, for example, amplifies the voltage between both ends of the detection coil 11. The synchronous detection circuit 32, for example, detects an output voltage of the amplifier circuit 31 according to a control signal supplied from the control circuit 40. The switching circuit 33, for example, switches between whether or not to output an output voltage of the synchronous detection circuit 32 to the low-pass filter 34 according to the control signal supplied from the control circuit 40.

The low-pass filter 34 functions as, for example, an integrating circuit that integrates a voltage from the switching circuit 33 (i.e., voltage from the synchronous detection circuit 32). The A/D converter 35, for example, converts an output voltage of the low-pass filter 34 into a digital signal, and outputs the digital signal to the comparison part 36. The comparison part 36, for example, compares the digital signal outputted from the A/D converter 35 with a predetermined threshold, and outputs a signal indicating the presence or absence of a detection object according to a result of the comparison. If the digital signal is equal to or greater than the predetermined threshold, the comparison part 36 outputs a signal indicating that the detection object exists within an operation region of the proximity sensor. If the digital signal does not exceed the predetermined threshold, the comparison part 36 outputs a signal indicating that the detection object does not exist within the operation region of the proximity sensor.

The control circuit 40, for example, controls the synchronous detection circuit 32 and the switching circuit 33 by supplying control signals to the synchronous detection circuit 32 and the switching circuit 33 respectively. Also, the control circuit 40, for example, supplies the signal S1 for turning on the switches 21 and 22 and the signal S2 for turning on the switches 23 and 24 to the switches 21 to 24 based on a random number supplied from the randomizer 50 to be described later, so that fall timing of the signal S1 and the signal S2 become aperiodic. Here, "aperiodic" includes when a time interval between one operation and the next operation varies at least once during a predetermined period if the operation occurs repeatedly. Also, "aperiodic" may include a situation in which the time interval between one operation and the next operation always varies during the predetermined period. As a result, a timing that defines a start timepoint of a detection period D to be described later (that is, a timing at which the excitation current supplied to the detection coil 11 is cut off) is aperiodic. In particular, the control circuit 40, for example, may generate the signals S1 and S2 so as to vary at least one of the supply period during which the excitation circuit 20 supplies the excitation current to the detection coil 11 and the cutoff period during which the excitation circuit 20 does not supply the excitation current to the detection coil 11.

The randomizer 50 generates a random number and supplies the generated random number to the control circuit 40. The configuration of the randomizer 50 is not particularly limited, and the randomizer 50 may be composed of, for example, hardware or software.

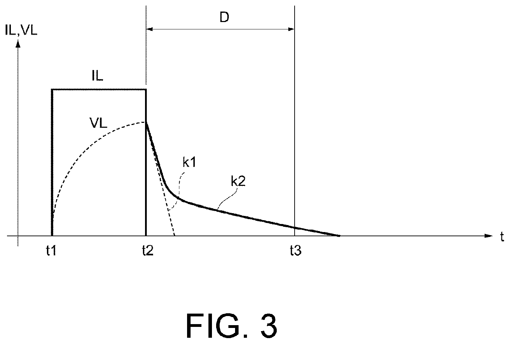

Next, an operation principle of a proximity sensor according to the present embodiment will be described with reference to FIGs. 2 and 3. FIG. 2 is a circuit block diagram exemplifying a schematic configuration of basic parts of a proximity sensor. FIG. 3 exemplifies a schematic waveform diagram for explaining an excitation current and a coil voltage generated in a detection coil.

In the example of FIG. 2, the proximity sensor 100, the detection coil 11, a core 14 around which the detection coil 11 is wound, the discharge resistor 13, a constant current circuit 26 for supplying an excitation current to the detection coil 11, a switch SW to be turned on/off in response to the signal S1, the amplifier circuit 31, the switching circuit 33 to be turned on/off in response to a control signal supplied from the control circuit 40, and the low-pass filter 34 are shown. The switch SW in FIG. 2 collectively shows the switches 21 and 22 as shown in FIG. 1.

In the example of FIG. 3, first of all, the signal S1 rises at time t1, so that the switch SW is turned on. As a result, an excitation current IL flows through the detection coil 11, and a coil voltage VL of the detection coil 11 rises at a predetermined time constant (L/R). Next, the signal S1 falls at time t2, so that the switch SW is turned off. As a result, the supply of the excitation current IL to the detection coil 11 is cut off.

If the detection object 200 is not disposed in the proximity of the proximity sensor 100, when the supply of the excitation current IL to the detection coil 11 is cut off, the coil voltage VL of the detection coil 11 is decreased sharply by the discharge resistor 13, as indicated by a curve k1.

On the other hand, if the detection object 200 is disposed in the proximity of the proximity sensor 100, when the supply of the excitation current IL to the detection coil 11 is cut off, the coil voltage VL of the detection coil 11 decreases slower than the curve k1, as shown by a curve k2. This is based on the following principle. That is, when the detection object 200 is disposed in the proximity of the proximity sensor 100, a magnetic flux is supplied to the detection object 200 by the detection coil 11 during the period from time t1 to time t2. Then, at time t2, when the current supply to the detection coil 11 is cut off, the supply of the magnetic flux from the detection coil 11 to the detection object 200 is also cut off, so that an eddy current is generated in the detection object 200. Then, a magnetic flux generated by the eddy current interlinks with the detection coil 11 so that an induced voltage is generated in the detection coil 11. A time constant of the induced voltage is larger than a time constant of an induced voltage of the detection coil 11 itself. Therefore, the coil voltage VL decreases slower than the curve k1 as shown by the curve k2.

The detection circuit 30 and the control circuit 40 detect the presence or absence of the detection object 200 based on a waveform difference of the coil voltage VL according to the presence or absence of the detection object 200 as described above. Specifically, the coil voltage VL generated in the detection coil 11 is amplified by the amplifier circuit 31 and outputted to the synchronous detection circuit 32. The synchronous detection circuit 32 detects the output voltage outputted from the amplifier circuit 31 according to the control signal supplied from the control circuit 40, and outputs a predetermined detection signal to the switching circuit 33. The control circuit 40 supplies the control signal to the switching circuit 33 so that the switching circuit 33 is turned on during the detection period D from time t2 to time t3 after lapse of a predetermined period.

During the detection period D, the detection signal outputted by the synchronous detection circuit 32 is outputted to the low-pass filter 34 via the switching circuit 33. The low-pass filter 34 smoothens, by time-integrating, the detection signal inputted from the synchronous detection circuit 32 via the switching circuit 33, and outputs the detection signal to the A/D converter 35. The A/D converter 35 converts an analog signal outputted from the low-pass filter 34 into a digital signal, and outputs the digital signal to the comparison part 36. The comparison part 36 determines the presence or absence of the detection object 200 by comparing the digital signal outputted from the A/D converter 35 with the predetermined threshold.

Also, the detection period D may start from a timepoint when the predetermined period (mask time) has elapsed from time t2.

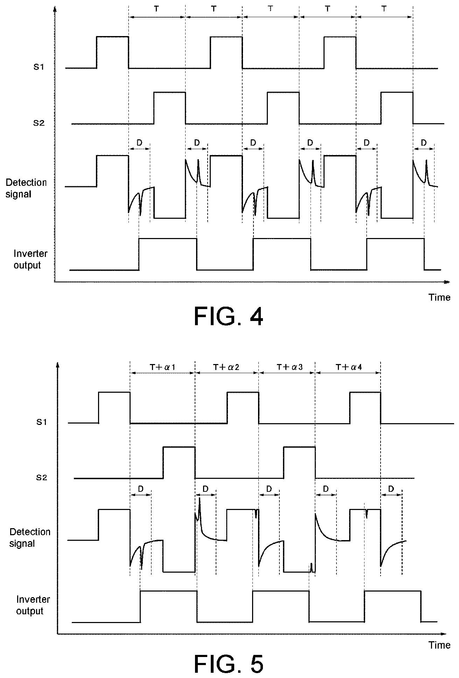

Next, with reference to FIGs. 4 and 5, the effect of reducing the influence of periodic noise according to the present embodiment will be described. Below, a case will be described as an example where, by alternately supplying the signals S1 and S2 by the control circuit 40, the detection coil 11 operates according to a method (so-called "alternate excitation method") of alternately flowing an excitation current in the + direction and the - direction as shown in FIG. 1.

FIG. 4 exemplifies an operation waveform diagram of a conventional proximity sensor. A conventional proximity sensor basically has the same configuration as the proximity sensor 100 according to the present embodiment, except that the conventional proximity sensor does not include the randomizer 50. Also, in the proximity of the conventional proximity sensor, an inverter for generating a periodic pulsed output voltage is disposed.

In the example of FIG. 4, the pulsed signal S1 for turning on the switches 21 and 22 and the pulsed signal S2 for turning on the switches 23 and 24 are supplied from the control circuit 40 to the excitation circuit 20 according to a predetermined period T. Then, based on a detection signal (coil voltage VL) generated in the detection coil 11 during the predetermined detection period D from the fall of each of the signals S1 and S2, the detection circuit 30 and the control circuit 40 determine the presence or absence of the detection object 200.

Here, the inverter disposed in the proximity of the conventional proximity sensor is assumed to generate a pulsed output voltage at a period substantially equal to the period T of the signals S1 and S2 described above. At this time, depending on the timing of operation of the conventional proximity sensor and the inverter, noise due to an output voltage of the inverter is generated in the detection signal (coil voltage VL) during the detection period D. For example, in the example of FIG. 4, the noise appears in the detection signal at substantially the same timing in any of a plurality of the detection periods D. As a result, the conventional proximity sensor may erroneously determine that the detection object 200 is detected, although the detection object 200 is not disposed in the proximity. Also, since the period of the output voltage of the inverter is equal to the period T of the signals S1 and S2 from the conventional proximity sensor, even if processing of averaging detection signals during a predetermined period or processing of counting is executed, the influence of such periodic noise cannot be removed.

FIG. 5 exemplifies an example of an operation waveform diagram of a proximity sensor according to the present embodiment. In the proximity of the proximity sensor 100, an inverter similar to the inverter described above is disposed.

In the example of FIG. 5, the control circuit 40 alternately and repeatedly supplies the pulsed signal S1 for turning on the switches 21 and 22 and the pulsed signal S2 for turning on the switches 23 and 24 to the excitation circuit 20. At this time, the control circuit 40 generates the signals S1 and S2 so that the fall timing of the signals S1 and S2 becomes aperiodic. Specifically, in the example of FIG. 5, a period from when the signal S1 (S2) falls to when the signal S2 (S1) falls immediately thereafter can be sequentially expressed as "T + α1", "T + α2", "T + α3", "T + α4", ... , etc. Here, T is a predetermined fixed value and α1, α2, α3, α4, ..., etc. are variables that may take on different values. As a result, since the timing at which the supply of the excitation current to the detection coil 11 is cut off is aperiodic, the start timepoint of the detection period D is also aperiodic.

Furthermore, since the start timepoint of the detection period D is aperiodic, even if noise from outside is periodic, the probability of the noise appearing in the detection signal during the detection period D becomes small. For example, in the example of FIG. 5, it may be observed that in some of the detection periods D, the noise due to the inverter does not appear in the detection signal. Also, even if the noise appears in the detection signal, the timing at which the noise appears in the detection signal during the detection period D is not constant. For example, in the example of FIG. 5, it may be observed that even when the noise due to the inverter appears in the detection signal, the timing at which the noise appears may be different for each of the detection periods D. Therefore, it may be said that the influence of periodic noise is reduced by the proximity sensor 100.

As described above, in the present embodiment, since the timing of cutting off the supply of the excitation current to the detection coil is aperiodic, the start timepoint of the detection period is also aperiodic. Therefore, even if the noise is periodic, the probability of the noise appearing in the detection signal during the detection period becomes small. Also, even if the noise appears in the detection signal, the timing at which the noise appears in the detection signal during the detection period is not constant. Therefore, the influence of periodic noise on the proximity sensor is reduced.

### [Description of Reference Numerals]

11: detection coil
12: auxiliary coil
13: discharge resistor
14: core
20: excitation circuit
21, 22, 23, 24, SW: switch
25, 26: constant current circuit
30: detection circuit
31: amplifier circuit
32: synchronous detection circuit
33: switching circuit
34: low-pass filter
35: Analog/Digital converter
36: comparison part
40: control circuit
50: randomizer
100: proximity sensor
200: detection object
α1, α2, α3, α4: variable
D: detection period
IL: excitation current
k1, k2: curve
S1, S2: signal
T: period
t1, t2, t3: time
VL: coil voltage

## Claims

1. A proximity sensor (100) for detecting a detection object (200) using a magnetic field, comprising:
a detection coil (11) for generating the magnetic field, the detection coil (11) comprising a first end and a second end;
an excitation circuit (20) for repeatedly supplying a pulsed excitation current to the detection coil (11), wherein the excitation circuit (20) includes first to fourth switches (21, 22, 23, 24), wherein the first end of the detection coil (11) is coupled between the first switch (21) and the fourth switch (24), and the second end of the detection coil (11) is coupled between the second switch (22) and the third switch (23) through an auxiliary coil (12);
a detection circuit (30) for detecting the detection object (200) based on a voltage generated across the first end and the second end of the detection coil (11) during a predetermined period after the supply of the excitation current is cut off, and
a control circuit (40) for controlling the excitation circuit (20) so that a timing of cutting off the supply of the excitation current to the detection coil (11) becomes aperiodic, wherein the control circuit (40) is configured to alternately and repeatedly supply a first signal (S1) for turning on the first and second switches (21, 22) and a second signal (S2) for turning on the third and fourth switches (23, 24), so that periods from when the first signal (S1) falls to when the second signal (S2) falls become aperiodic.

2. The proximity sensor (100) according to claim 1, wherein the control circuit (40) controls the excitation circuit (20) by varying at least one of a supply period during which the excitation circuit (20) supplies the excitation current to the detection coil (11) and a cutoff period during which the excitation circuit (20) does not supply the excitation current to the detection coil (11), so that the timing of cutting off the supply of the excitation current to the detection coil (11) becomes aperiodic.

3. The proximity sensor (100) according to claim 1 or 2, further comprising:
a randomizer (50) for generating a random number,
wherein the control circuit (40) controls the excitation circuit (20) based on the random number generated by the randomizer, so that the timing of cutting off the supply of the excitation current to the detection coil (11) becomes aperiodic.

## Patentansprüche

1. Näherungssensor (100) zum Detektieren eines Detektionsobjekts (200) unter Verwendung eines Magnetfelds, wobei der Näherungssensor umfasst:
eine Detektionsspule (11) zum Erzeugen des Magnetfelds, wobei die Detektionsspule (11) ein erstes Ende und ein zweites Ende besitzt;
eine Erregungsschaltung (20) zum wiederholten Zuführen eines gepulsten Erregungsstroms zu der Detektionsspule (11), wobei die Erregungsschaltung (20) einen ersten bis vierten Schalter (21, 22, 23, 24) enthält, wobei das erste Ende der Detektionsspule (11) zwischen den ersten Schalter (21) und den vierten Schalter (24) gekoppelt ist und das zweite Ende der Detektionsspule (11) über eine Zusatzspule (12) zwischen den zweiten Schalter (22) und den dritten Schalter (23) gekoppelt ist;
eine Detektionsschaltung (30) zum Detektieren des Detektionsobjekts (200) auf der Grundlage einer über das erste Ende und das zweite Ende der Detektionsspule (11) erzeugten Spannung während einer vorgegebenen Zeitdauer, nachdem die Zufuhr des Erregungsstroms ausgeschaltet worden ist, und
eine Steuerschaltung (40) zum Steuern des Erregungsstroms (20) in der Weise, dass ein Zeitpunkt des Ausschaltens der Zufuhr des Erregungsstroms zu der Detektionsspule (11) aperiodisch wird, wobei die Steuerschaltung (40) dafür konfiguriert ist, ein erstes Signal (S1) zum Einschalten des ersten und des zweiten Schalters (21, 22) und ein zweites Signal (S2) zum Einschalten des zweiten und des vierten Schalters (23, 24) abwechselnd und wiederholt in der Weise zuzuführen, das die Zeitdauern von dem Zeitpunkt, zu dem das erste Signal (S1) fällt, bis zu dem Zeitpunkt, zu dem das zweite Signal (S2) fällt, aperiodisch werden.

2. Näherungssensor (100) nach Anspruch 1, wobei die Steuerschaltung (40) die Erregungsschaltung (20) durch Variieren einer Zufuhrzeitdauer, während der die Erregungsschaltung (20) der Detektionsspule (11) den Erregungsstroms zuführt, und/oder einer Ausschaltzeitdauer, während der die Erregungsschaltung (20) der Detektionsspule (11) den Erregungsstroms nicht zuführt, in der Weise steuert, dass der Zeitpunkt des Ausschaltens der Zufuhr des Erregungsstroms zu der Detektionsspule (11) aperiodisch wird.

3. Näherungssensor (100) nach Anspruch 1 oder 2, der ferner umfasst:
einen Zufallsgenerator (50) zum Erzeugen einer Zufallszahl,
wobei die Steuerschaltung (40) die Erregungsschaltung (20) auf der Grundlage der durch den Zufallsgenerator erzeugten Zufallszahl in der Weise steuert, dass ein Zeitpunkt des Ausschaltens der Zufuhr des Erregungsstroms zu der Detektionsspule (11) aperiodisch wird.

## Revendications

1. Capteur de proximité (100) pour détecter un objet de détection (200) en utilisant un champ magnétique, comportant :
une bobine de détection (11) pour générer le champ magnétique, la bobine de détection (11) comportant une première extrémité et une seconde extrémité ;
un circuit d'excitation (20) pour fournir de manière répétée un courant d'excitation pulsé à la bobine de détection (11), dans lequel le circuit d'excitation (20) inclut des premier à quatrième commutateurs (21, 22, 23, 24), dans lequel la première extrémité de la bobine de détection (11) est couplée entre le premier commutateur (21) et le quatrième commutateur (24), et la seconde extrémité de la bobine de détection (11) est couplée entre le deuxième commutateur (22) et le troisième commutateur (23) par l'intermédiaire d'une bobine auxiliaire (12) ;
un circuit de détection (30) pour détecter l'objet de détection (200) sur la base d'une tension générée à travers la première extrémité et la seconde extrémité de la bobine de détection (11) pendant une période prédéterminée après la coupure de la fourniture du courant d'excitation, et
un circuit de commande (40) pour commander le circuit d'excitation (20) de sorte qu'une temporisation de la coupure de la fourniture du courant d'excitation à la bobine de détection (11) devient apériodique, dans lequel le circuit de commande (40) est configuré pour fournir de manière alternée et répétée un premier signal (S1) pour mettre à l'état passant les premier et deuxième commutateurs (21, 22) et un second signal (S2) pour mettre à l'état passant les troisième et quatrième commutateurs (23, 24), de sorte que des périodes allant depuis l'instant où le premier signal (S1) décroît jusqu'à l'instant où le second signal (S2) décroît deviennent apériodiques.

2. Capteur de proximité (100) selon la revendication 1, dans lequel le circuit de commande (40) commande le circuit d'excitation (20) en faisant varier au moins une période parmi une période de fourniture pendant laquelle le circuit d'excitation (20) fournit le courant d'excitation à la bobine de détection (11) et une période de coupure pendant laquelle le circuit d'excitation (20) ne fournit pas le courant d'excitation à la bobine de détection (11), de sorte que la temporisation de la coupure de la fourniture du courant d'excitation à la bobine de détection (11) devient apériodique.

3. Capteur de proximité (100) selon la revendication 1 ou 2, comportant en outre :
un générateur de nombre aléatoire (50) pour générer un nombre aléatoire,
dans lequel le circuit de commande (40) commande le circuit d'excitation (20) sur la base du nombre aléatoire généré par le générateur de nombre aléatoire, de sorte que la temporisation de la coupure de la fourniture du courant d'excitation à la bobine de détection (11) devient apériodique.
